(19) Europäisches Patentamt
European Patent Office
Office européen des brevets

(11) **EP 1 685 421 B1**

(12) **EUROPEAN PATENT SPECIFICATION**

(45) Date of publication and mention
of the grant of the patent:
**15.10.2008 Bulletin 2008/42**

(51) Int Cl.:
**G01R 33/567** (2006.01)

(21) Application number: **04799053.6**

(22) Date of filing: **03.11.2004**

(86) International application number:
**PCT/IB2004/052286**

(87) International publication number:
**WO 2005/047920 (26.05.2005 Gazette 2005/21)**

(54) **READOUT ORDERING IN COLLECTION OF RADIAL MAGNETIC RESONANCE IMAGING DATA**

AUSLESEREIHENFOLGE BEIM SAMMELN RADIALER MAGNETRESONANZ-BILDDATEN

ORDONNANCEMENT DE LECTURE DANS LA COLLECTE DE DONNEES RADIALES D'IMAGERIE PAR RESONANCE MAGNETIQUE

(84) Designated Contracting States:
**AT BE BG CH CY CZ DE DK EE ES FI FR GB GR HU IE IS IT LI LU MC NL PL PT RO SE SI SK TR**

(30) Priority: **13.11.2003 US 519836 P**

(43) Date of publication of application:
**02.08.2006 Bulletin 2006/31**

(73) Proprietor: **Koninklijke Philips Electronics N.V.
5621 BA Eindhoven (NL)**

(72) Inventor: **DANNELS, Wayne, R.
Cleveland, OH 44143 (US)**

(74) Representative: **Cohen, Julius Simon
Philips
Intellectual Property & Standards
P.O. Box 220
5600 AE Eindhoven (NL)**

(56) References cited:
**EP-A- 0 218 838          EP-A- 0 981 058**

• **VAN DE WALLE R ET AL: "Projection reconstruction MR imaging for the reduction of artifacts caused by interview motion" IEEE TRANSACTIONS ON NUCLEAR SCIENCE, vol. 46, no. 6, 1999, pages 2253-2258, XP002321151 ISSN: 0018-9499**
• **SCHAFFTER T ET AL: "Motion compensated projection reconstruction" MAGNETIC RESONANCE IN MEDICINE, vol. 41, no. 5, 1999, pages 954-963, XP002321152 ISSN: 0740-3194**

**Description**

The following relates to the magnetic resonance arts. It finds particular application in magnetic resonance imaging employing radial collection of data, and will be described with particular reference thereto. However, it also finds application in other magnetic resonance applications such as magnetic resonance spectroscopy.

Motion artifacts are a well-known problem both in magnetic resonance imaging and in other imaging modalities. Acquisition of sufficient imaging data for reconstruction of an image takes a finite period of time. Motion of the imaging subject during that finite acquisition time typically results in motion artifacts in the reconstructed image. In the case of medical imaging, motion artifacts can result for example from cardiac cycling, respiratory cycling, and other physiological processes, as well as from patient motion.

In radial magnetic resonance imaging data acquisition, a plurality of readout lines or "projections" are acquired over a span of projection angles. Motion-related image artifacts in images reconstructed from radially acquired magnetic resonance imaging data include a general blurring of the moving object and streaking artifacts that extend from the moving object some distance across the image. The general blurring reduces image resolution of the moving object, while motion-related streak artifacts can produce distinct and sharp artifact features where streaks overlap. In the case of complex motions, streaking artifacts can extend in multiple directions all across the image.

Gated imaging is sometimes used to reduce motion artifacts. In gated imaging, data collection is timed with a gating signal correlated with the motion. For example, in cardiac gated imaging an electrocardiograph or other heart monitor is used to track the cardiac cycle. Imaging data acquisition is temporally restricted to a small portion of the cardiac cycle over which the motion is limited. To acquire a sufficient amount of data for image reconstruction, gated data is acquired over several cardiac cycles. However, motion, including translational motion, of the imaged subject across heartbeats causes misregistry of the data from the successive cardiac cycles. This misregistry corresponds to motion artifacts in the reconstructed image.

A magnetic resonance imaging method is known from EP 0 218 838 A2. In this known method the phase of a substantially periodic signal variation is measured in order to enable reduction of image artifacts that are due to motion of the imaged object. A predetermined relationship between the measured motion phase and the applied magnetic field gradient values is approximated by selecting a temporal order of application of magnetic field gradient values. The essential feature of the known method is that this temporal order is based on the motion phase measurements. A drawback of this technique is that motion induced image artifacts are still present. By the temporal ordering of applied magnetic field gradient values during image acquisition the motion-induced artifacts (also referred to as ghosts) are either within a few pixels of the respective source point and cause blurring, or the ghosts are displaced as far as possible from the moving image feature and do thus not cause blurring but significantly restrict the effective field of view.

The present invention contemplates an improved apparatus and method that overcomes the aforementioned limitations and others.

According to one aspect, a magnetic resonance imaging apparatus is disclosed. A means is provided for acquiring radial readout lines of magnetic resonance imaging data. A means is provided for reconstructing the acquired readout lines into reconstructed image data. A means is provided for determining a displacement of a feature of interest of a subject undergoing imaging. A means is provided for coordinating a direction of the radial readout lines with the displacement of the feature of interest. The coordinating means is arranged to select radial readout lines to have readout magnetic field gradient directions transverse to the displacement.

According to another aspect, a magnetic resonance imaging method is provided. A displacement of a feature of interest of a subject undergoing imaging is determined. A direction of a radial readout line is selected based on the determined displacement. A radial readout line of magnetic resonance imaging data is acquired using a readout magnetic field gradient having the selected direction. The determining, selecting, and acquiring are repeated to collect a dataset of radial readout lines. The dataset of radial readout lines are reconstructed into reconstructed image data. Selecting of a direction includes orienting the radial readout line direction transverse to the displacement.

One advantage resides in reduced motion artifacts in images reconstructed from radially collected magnetic resonance imaging data.

Another advantage resides in reduced streaking artifacts in images reconstructed from radially collected magnetic resonance imaging data.

Numerous additional advantages and benefits will become apparent to those of ordinary skill in the art upon reading the following detailed description of the preferred embodiments.

The invention may take form in various components and arrangements of components, and in various process operations and arrangements of process operations. The drawings are only for the purpose of illustrating preferred embodiments and are not to be construed as limiting the invention, which is defined in the claims.

FIGURE 1 diagrammatically shows a magnetic resonance imaging system employing a selected readout ordering during radial collection of imaging data. In FIGURE 1, the magnetic resonance imaging scanner is illustrated with about one-half of the scanner cut away to reveal internal components of the scanner and to reveal an associated imaging subject disposed in the scanner bore.

FIGURE 2 diagrammatically shows how the angle or direction between readout magnetic field gradient and displacement of a feature of interest affects motion artifacting of a reconstructed image of that feature of interest.

FIGURE 3 diagrammatically shows a suitable process for selecting a readout ordering that substantially reduces motion artifacts in the reconstructed image of a feature of interest that follows an oval displacement trajectory.

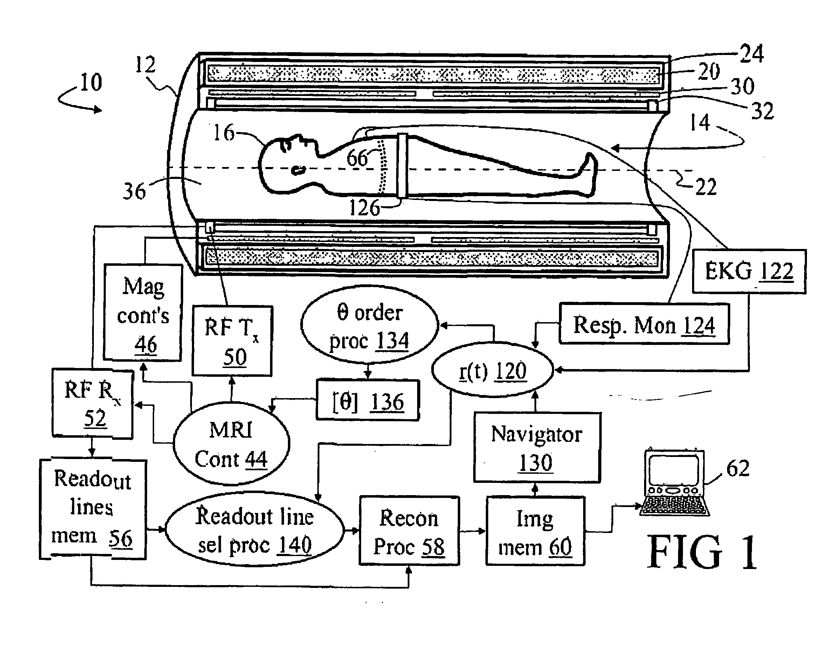

With reference to FIGURE 1, a magnetic resonance imaging scanner **10** includes a housing **12** defining a generally cylindrical scanner bore **14** inside of which an associated imaging subject **16** is disposed. Main magnetic field coils **20** are disposed inside the housing **12**. The main magnetic field coils **20** are arranged in a generally solenoidal configuration to produce a main $B_o$ magnetic field directed along a central axis **22** of the scanner bore **14**. The main magnetic field coils **20** are typically superconducting coils disposed inside in cryoshrouding **24,** although resistive main magnets can also be used. Moreover, the scanner **10** may include additional access openings other than the ends of the cylindrical scanner bore **14** for accessing the imaging subject **16**. For example, rather than a closed solenoidal configuration having a closed generally "O"-shaped cross-section, a more open generally "U"-shaped cross-sectional magnet can be employed.

The housing **12** also houses or supports magnetic field gradient coils **30** for selectively producing magnetic field gradients parallel to the central axis **22** of the bore **14,** along directions transverse to the central axis **22,** or along other selected directions. The housing **12** also houses or supports a birdcage radio frequency body coil **32** for selectively exciting and/or detecting magnetic resonances. Other coils besides a birdcage coil can be used, such as a transverse electromagnetic (TEM) coil, a phased coil array, or other type of radio frequency coil. Moreover, a local coil such as a head coil or a surface coil or coil array can be used. The housing **12** typically includes a cosmetic inner liner **36** defining the scanner bore **14.**

The main magnetic field coils **20** produce a main magnetic field $B_o$. A magnetic resonance imaging controller **44** operates magnet controllers **46** to selectively energize the magnetic field gradient coils **30,** and operates a radio frequency transmitter **50** coupled to the radio frequency coil **32** to selectively energize the radio frequency coil **32**. By selectively operating the magnetic field gradient coils **30** and the radio frequency coil **32,** magnetic resonance is generated and spatially encoded in at least a portion of a selected region of interest of the imaging subject **16**. The magnetic resonance imaging controller **44** operates a radio frequency receiver **52** coupled to the radio frequency coil **32** along with the gradient coils **30** to read out selected radial magnetic resonance readout lines which are stored in a readout lines memory **56**. Rather than using the illustrated coil **32,** a local coil, surface coil, phase coils array, or the like can be used for radio frequency transmission or receiving.

A reconstruction processor **58** applies a suitable reconstruction algorithm to reconstruct the readout lines into a reconstructed image including at least a portion of the region of interest of the imaging subject. The reconstructed image is stored in an image memory **60,** displayed on a user interface **62,** stored in non-volatile memory, transmitted over a local intranet or the Internet, or otherwise viewed, stored, manipulated, or so forth. The user interface **62** can also enable a radiologist, technician, or other operator of the magnetic resonance imaging scanner **10** to communicate with the magnetic resonance imaging controller **44** to select, modify, and execute magnetic resonance imaging sequences.

In a radial scanning mode, magnetic resonance is excited in a volume, slab, or slice of interest defined by magnetic field gradients applied during radio frequency excitation. For example, a slice-selective magnetic field gradient applied along the central axis **22** of the scanner bore **14** enables selective magnetic resonance excitation of an axial slice of the imaging subject **16,** such as an example axial slice **66** indicated in FIGURE 1. Imaging data of the excited volume, slab, or slice are read out as radial readout lines. Each radial readout line is acquired by applying a readout magnetic field gradient along a selected direction during receiving of the magnetic resonance signal.

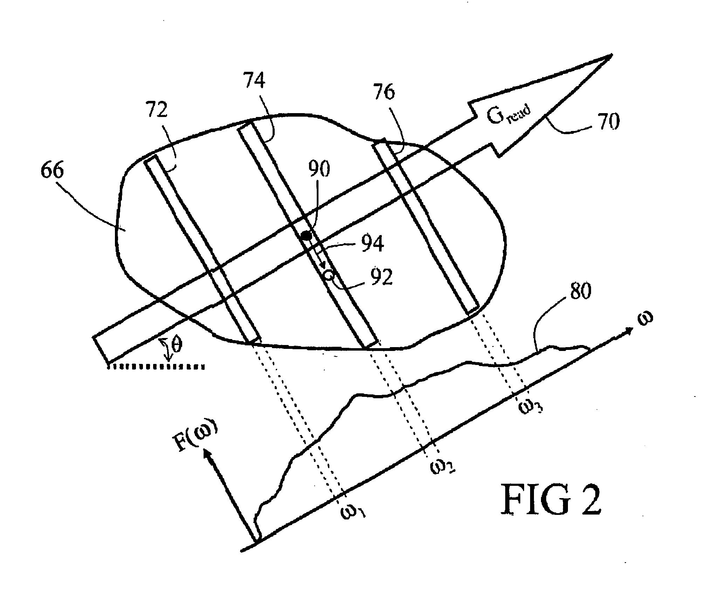

With reference to FIGURE 2, a diagrammatic example of radial readout of the slice **66** is shown. A direction of a readout magnetic field gradient $G_{read}$ is indicated by the large arrow **70**. The readout magnetic field gradient **70** produces a monotonically increasing frequency of the magnetic resonance signal along the gradient **70,** while the frequency of the magnetic resonance signal remains constant along a direction transverse to the gradient **70**. Thus, for example, a thin portion or column **72** of the slice **66** oriented transverse to the direction of the readout magnetic field gradient **70** emanates magnetic resonance with frequencies lying within a first frequency bin having center frequency $\omega_1$. Another thin portion or column **74** of the slice **66** parallel to the thin portion **72** but disposed further along the gradient **70** emanates magnetic resonance with frequencies lying within a second frequency bin having center frequency $\omega_2$ that is higher than the first center frequency $\omega_1$. Yet another thin portion or column **76** of the slice **66** parallel to the thin portions **72, 74** but disposed still further along the gradient **70** emanates magnetic resonance with frequencies lying within a third frequency bin having center frequency bin $\omega_3$ that is higher than either of the first or second center frequencies $\omega_1$, $\omega_2$.

While three example portions **72, 74, 76** are illustrated, it will be appreciated that a continuum of frequencies are generated along the direction of the readout magnetic field gradient **70**. A Fourier transform of the magnetic resonance signal produces a frequency spectrum **80** illustrated in FIGURE 2 which corresponds to the radial readout magnetic resonance signal using the readout magnetic field gradient **70** oriented at an angle θ. If a discrete Fourier transform is used, the frequencies are binned into frequency bins such as the illustrated frequency bins having center frequencies $\omega_1$, $\omega_2$, $\omega_3$. In a similar manner, other radial readouts are acquired along other angles.

The radial readout directions may be disposed in a plane, which is conductive to reconstruction of two-dimensional image slices. Optionally, multiple slices can be acquired in this manner to produce a three-dimensional volume image. Alternatively, the radial readout directions may be distributed three-dimensionally along a sphere or hemisphere, which is conductive to reconstruction of three-dimensional volume images.

In the two-dimensional case, typically, a dataset of radial readouts having angles spanning at least about 180° and optionally a larger span such as 360° are acquired and reconstructed by the reconstruction processor **58** into reconstructed image data. In the two-dimensional case, the gradient $G_{read}$ used for acquiring data for the slice **66** is suitably characterized by the angle θ. However, the readout gradient can also be described as a vector in two- or three-dimensions for other radial magnetic resonance imaging data acquisition approaches.

In one suitable reconstruction, the Fourier transform spectra of the radial readouts are reconstructed using a filtered backprojection reconstruction algorithm. A large number of other reconstruction algorithms are also suitable for reconstructing radial readout magnetic resonance imaging data into reconstructed image data. These reconstructions may operate on the readout signals and/or on the Fourier transform of the readout signals.

With continuing reference to FIGURE 2, a feature of interest **90** is illustrated. The feature **90** may, for example, represent a blood vessel of interest, a tumor, a damaged region of the heart or of a lung, or so forth. The feature of interest **90** may move during acquisition of the radial readout lines. For example, if the feature **90** is illustrated in a reference position, the feature may move to a displaced position **92** corresponding to a displacement **94** (indicated by an arrow in FIGURE 2) respective to the original reference position. This motion may be due, for example, to the coronary or pulmonary cycle of the patient.

Generally, such motion manifests as motion artifacts in the reconstructed image. However, it will be noted that the displacement **94** lies within the thin portion **74**. When the direction of the readout magnetic field gradient **70** is orthogonal to the displacement, the magnetic resonance signal emanating from the feature of interest **90** is unchanged by the displacement **94**. Similarly, the Fourier spectrum 80 is unchanged by the displacement **94**. In the reference position, the feature **90** emanates magnetic resonance at about the center frequency $\omega_2$. When the feature **90** is displaced to the position **92** corresponding to the displacement **94** which is transverse to the direction of the readout magnetic field gradient **70,** the feature **90** also emanates magnetic resonance at about the center frequency $\omega_2$. Indeed, the feature **90** can be displaced anywhere in the thin portion or column **74** without changing its magnetic resonance signal frequency, and without altering the Fourier frequency spectrum **80** or the corresponding time domain magnetic resonance signal. Note that if the readout gradient was instead parallel to the displacement **94,** the magnetic resonance signal from the feature **90** would be spread out over a plurality of adjacent thin portions or columns spanned by the displacement **94**. As a result, when the radial readout lines are acquired such that during each radial readout line acquisition the direction of the readout magnetic field gradient is generally transverse to the displacement, motion artifacts are substantially reduced.

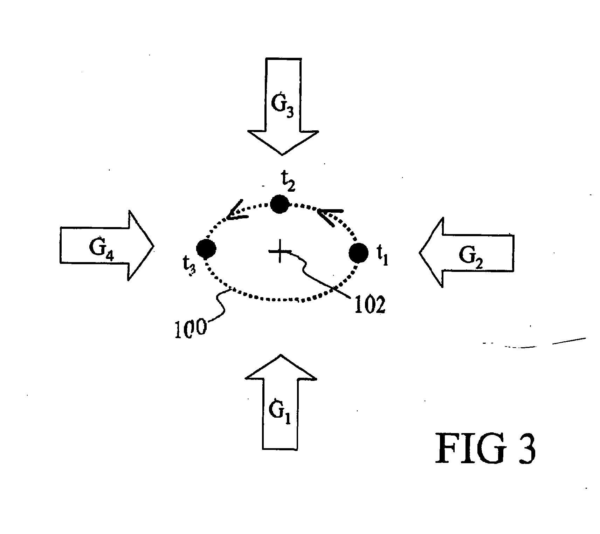

With reference to FIGURE 3, in one example of motion artifact suppression, a feature of interest follows an oval cyclic displacement trajectory **100** (indicated by a dotted trajectory path and directional arrowhead indicators) relative to a reference position **102** (indicated by crosshairs). At a time $t_1$, either one of positive or negative readout gradients $G_1$, $G_3$ having directions transverse to the displacement of the feature at time $t_1$ is optimally used in acquiring a radial readout line of magnetic resonance data. Similarly, at a time $t_2$ subsequent to time $t_1$, either one of positive or negative readout gradients $G_2$, $G_4$ having directions transverse to the displacement of the feature at time $t_2$ is optimally used in acquiring a radial readout line of magnetic resonance data. Typically, an angular span of about 180° or more is acquired. At a time $t_3$ subsequent to times $t_1$ and $t_2$, the gradient $G_1$ or $G_3$ not used at time $t_1$ is optimally used to acquire a radial readout line at time $t_3$.

In some cases, it may be difficult or impossible to order the readout angles or directions such that each readout is acquired with the displacement transverse to the readout direction. For example, in the case of a linear displacement trajectory, only two readout gradient directions are exactly orthogonal to the linear displacement. However, by biasing the selection of the radial readout angles or directions respective to the displacement trajectory such that readouts at times of maximum displacement of the feature of interest employ readout gradients that are generally transverse to those maximum displacements, motion artifacts can be substantially reduced. Readout gradient directions that cannot be timed to be close to orthogonal to the linear trajectory are acquired at times of minimal displacement of the feature of interest.

Other displacement trajectories besides linear trajectories can produce situations in which the advantageous displacement transverse to readout magnetic field gradient direction condition is difficult or impossible to satisfy for all radial readouts in a set of radial readouts spanning 180° or more. Moreover, the trajectory of a feature of interest may not be known with precision.

With reference returning to FIGURE 1, a displacement processor **120** determines a displacement r(t) as a function of time. The displacement processor **120** can determine displacement using various types of sensors. For example, a heart monitor such as an electrocardiogram (EKG) **122** measuring the cardiac cycle is suitable for monitoring displacement of vascular features of interest such as the heart and major blood vessels. A respiratory monitor **124** employing a respiratory bellows **126** or other device measuring the respiratory cycle is suitable for monitoring displacement of the lungs, diaphragm, ribs, or other anatomical feature that move in-synch with the respiratory cycle.

EKG and respiratory measurements are typically indirect measurements of motion. The actual motion of the feature of interest is estimated by the displacement processor **120** using a model relating feature motion with the measured cardiac or respiratory cycle. To construct the model, displacement monitoring by an indirect measure such as the EKG **122** or the respiratory monitor **124** can be calibrated using magnetic resonance imaging. The calibration relates displacement in two- or three-dimensions with the measured cardiac, respiratory, or other physiological cycle. Once calibrated, the indirect measurement of the cardiac, respiratory, or other physiological cycle can be employed to provide real-time displacement information.

Rather than employing an indirect measure, motion of the feature of interest can be determined by imaging the feature with the magnetic resonance imaging system. For cyclic motion of the feature of interest, the displacement processor **120** optionally determines the displacement r(t) as a function of time based on magnetic resonance imaging of several motion cycles. A navigator echo means **130** receives rapidly acquired magnetic resonance echoes that are interspersed among the imaging echoes to determine movement and location of the feature of interest.

Advantageously, the method uses relative displacements or trajectories, but can be applied independent of absolute positions. Thus, a motion model determined with a patient at one location in the bore may still be utilized if the patient moves translationally.

In the case of a relatively predictable cyclic displacement trajectory, the displacement calibration can be used to select an ordering of the readout lines that reduces motion artifacts. This can be done by selecting most readout lines to have readout magnetic field gradient directions transverse to the displacement. In this *a priori* ordering approach, an angular or gradient direction ordering processor **134** optimizes the angles (for two-dimensional imaging, for example the angle θ shown in FIGURE 2) or directions (for three-dimensional imaging) of the readout magnetic field gradients based on a suitable figure of merit, to produce a readout gradient angle or readout gradient direction ordering **136** that is implemented during magnetic resonance imaging by the magnetic resonance imaging controller **44.** Typically, the imaging will be gated by the cardiac cycle, respiratory cycle, or other reference physiological cycle.

As an example, for the case where the ordering processor **134** selects most readout lines to have readout magnetic field gradient directions transverse to the displacement, a suitable angular or directional ordering optimization method employs a least squares optimization according to:

$$ \text{FOM} = \sqrt{\sum_{N} \left( \underline{r}(t[n]) \bullet \underline{u}(\theta[n]) \right)^2 } \qquad (1), $$

where n indexes the readout line acquisition order and N is the total number of readout lines (that is, readouts n are acquired in order from n=1 to n=N), t[n] is the time of readout n referenced to a gating signal such as a beginning of the cardiac cycle or respiratory cycle, r(t[n]) is the displacement vector for readout n, $\underline{u}(\theta[n])$ is a unit vector in the direction of the readout magnetic field gradient used in readout n, the symbol **"•"** represents a vector dot product (the dot product $\underline{a} \bullet \underline{b}$ is identically zero when the vectors $\underline{a}$ and $\underline{b}$ are exactly orthogonal), and FOM is a figure of merit that is minimized in the least-squares sense with respect to the ordered set of angles or directions θ[n] to select most readout lines to have readout magnetic field gradient directions transverse to the displacement. The minimized value of the ordered set of angles θ[n] is the angle ordering **136.**

Advantageously, the least squares minimization approach biases the readout angle or direction selection toward orienting the readout magnetic field gradient direction generally transverse to the displacement. Moreover, the least squares minimization approach biases more strongly toward a transverse readout gradient for larger displacements. For relatively small magnitudes of displacement r(t[n]), the dot product $\underline{r}(t[n]) \bullet \underline{u}(\theta[n])$ is relatively small even if the displacement and gradient direction vectors are parallel or anti-parallel. In contrast, for large displacement magnitudes the expression $(\underline{r}(t[n]) \bullet u(\theta[n]))^2$ increases rapidly as the displacement and gradient direction vectors deviate from being orthogonal and begin to approach a parallel or anti-parallel orientation.

The *a priori* ordering approach is most effective where the displacement trajectory is cyclic and substantially regular and predictable. For irregular cyclic motion such as in the case of an irregular heartbeat, or for non-cyclic motion, the gradient angle or direction ordering processor **134** can operate substantially concurrently with the magnetic resonance imaging data acquisition to select readout gradient angles or directions for the readout lines on a substantially real-time basis during imaging data acquisition. In this approach, the displacement is determined by the displacement processor **120** just before acquisition of the next readout line. Before the first readout line is acquired, all readout angles or directions are yet to be acquired, and so a readout direction transverse to the measured displacement can be selected. As the number of acquired readout lines increases, the number of readout line angles or directions remaining to be acquired decreases. For later readout lines, the readout line most transverse to the current displacement may be significantly less than perfectly orthogonal. This difficulty can be addressed by acquiring redundant data for some, most, or all gradient angles or directions, thus increasing a likelihood that most gradient angles or directions are acquired with the displacement generally orthogonal thereto.

Rather than using the displacement trajectory information before or during magnetic resonance data acquisition to order the readout gradient directions before or during data acquisition, the displacement trajectory information can be used after data acquisition to optimally select from amongst a redundant number of readout lines an optimal dataset of readout lines for use in image reconstruction. In this approach, magnetic resonance data is collected while at substantially the same time monitoring the displacement of the feature of interest using the displacement processor **120** and associated sensors such as the EKG **122,** the respiratory monitor **124,** or the navigator **130.** Redundant readout data is collected; that is, more than one readout line is acquired for many, most, or all readout magnetic field gradient angles or directions. For each readout gradient angle or direction θ, there may be for example M acquired readout lines indexed i=1...M. Each acquired readout line has a corresponding displacement vector $\underline{r}[i]$ identifying the displacement at the time of that readout acquisition. A readout line selection processor **140** selects from amongst the M readout lines that readout line having the smallest dot product $\underline{r}[i] \cdot \underline{u}(\theta)$, where $\underline{u}(\theta)$ is a unit vector in the direction θ of the readout magnetic field gradient.

The selected readout lines form a dataset which is a sub-set of the acquired readout lines. The selected sub-set of readout lines are reconstructed by the reconstruction processor **58** to produce an image with reduced motion artifacts.

## Claims

1. A magnetic resonance imaging apparatus comprising:

   a means **(10, 44, 46, 50, 52)** for acquiring radial readout lines of magnetic resonance imaging data;
   a means **(58)** for reconstructing the acquired readout lines into reconstructed image data;
   a means **(120, 122, 124, 126, 130)** for determining a displacement of a feature of interest **(90)** of a subject **(16)** undergoing imaging; and
   a means **(134, 140)** for coordinating the directions of the radial readout lines with the displacement of the feature of interest **(90), characterised in that** the coordinating means **(134, 140)** is arranged to select radial readout lines to have readout magnetic field gradient directions transverse to the displacement.

2. The magnetic resonance imaging apparatus as set forth in claim 1, wherein the determining means **(120, 122, 124, 126, 130)** is selected from a group consisting of:

   a means **(122, 124, 126)** for measuring a physiological parameter correlated with displacement of the feature of interest, the displacement being determined based on the measured physiological parameter,
   a means **(130)** for extracting a position of the feature of interest from magnetic resonance imaging data acquired by the acquiring means **(10, 44, 46, 50, 52),** the displacement being determined as displacement of the position of the feature of interest from a reference position, and
   a magnetic resonance navigator **(130)** cooperating with the acquiring means **(10, 44, 46, 50, 52).**

3. The magnetic resonance imaging apparatus as set forth in claim **1,** wherein the coordinating means **(134, 140)** is arranged to compute an acquisition order **(136)** of radial readout lines, the acquisition order **(136)** being biased toward orienting the readout magnetic field gradient direction transverse to the displacement, the acquiring means **(10, 44, 46, 50, 52)** acquiring the readout lines of magnetic resonance imaging data in the acquisition order **(136).**

4. The magnetic resonance imaging apparatus as set forth in claim **1,** wherein the coordinating means **(134)** operates substantially concurrently with the acquiring means **(10, 44, 46, 50, 52),** the coordinating means **(134)** selecting a readout magnetic field gradient direction **(136)** of a next readout line acquisition based on a present displacement of the feature of interest.

5. The magnetic resonance imaging apparatus as set forth in claim **1,** wherein the coordinating means **(134, 140)** is arranged to select a dataset of acquired readout lines that is a sub-set of the acquired readout lines, the selecting being biased **(140)** toward selecting readout lines for which the readout magnetic field gradient direction is transverse to the displacement, the reconstructing means **(58)** reconstructing the dataset of acquired readout lines into reconstructed image data.

6. The magnetic resonance imaging apparatus as set forth in claim 1, wherein the coordinating means **(134, 140)** is further arranged to
   control the acquiring means to acquire readout lines of magnetic resonance imaging data having a selected ordering, and/or
   to select a dataset of acquired readout lines that is a sub-set of the acquired readout lines, the dataset having the selected ordering, the reconstructing means **(58)** reconstructing the dataset of acquired readout lines into reconstructed image data.

7. The magnetic resonance imaging apparatus as set forth in claim **1,** wherein the coordinating means **(134, 140)** is arranged to determine an optimized ordering **(136)** of a set of readout lines based on a cyclic displacement trajectory, the acquiring means **(10, 44, 46, 50, 52)** acquiring the radial readout lines of magnetic resonance imaging data using the optimized ordering **(136).**

8. The magnetic resonance imaging apparatus as set forth in claim 7, wherein the coordinating means **(134)** is arranged to optimize the ordering of the set of readout lines to minimize a figure of merit indicative of the selected relationship between readout magnetic field gradient direction and the determined displacement of the feature of interest.

9. A magnetic resonance imaging method comprising:

   determining a displacement of a feature of interest of a subject undergoing imaging;
   selecting a direction of a radial readout line based on the determined displacement,
   acquiring a radial readout line of magnetic resonance imaging data using a readout magnetic field gradient having the selected direction;
   repeating the determining, selecting, and acquiring to collect a dataset of radial readout lines; and
   reconstructing the dataset of radial readout lines into reconstructed image data; **characterised in that** the selecting of a direction includes orienting the radial readout line direction transverse to the displacement.

10. The magnetic resonance imaging method as set forth in claim **9,** wherein the determining of a displacement of a feature of interest is repeated to determine a cyclic displacement of the feature of interest, and the selecting of a direction of a radial readout line based on the determined displacement includes:

    optimizing an ordering of a set of readout lines with respect to the cyclic displacement of the feature of interest, the acquiring of a radial readout line of magnetic resonance imaging data including acquiring a plurality of readout lines in the selected ordering.

11. The magnetic resonance imaging method as set forth in claim **10,** wherein the optimizing of the ordering is such that when the displacement of the feature of interest is large the acquired radial readout line has a direction selected substantially orthogonal to the large displacement.

12. The magnetic resonance imaging method as set forth in claim **9,** wherein the determining of a displacement of a feature of interest is repeated to determine a cyclic displacement of the feature of interest, and the selecting of a direction of a radial readout line based on the determined displacement includes:

    selecting a sub-set of the acquired radial readout lines based on an angle between the readout line and the displacement of the feature of interest at the time the readout line was acquired, the reconstructing being performed on the selected sub-set.

13. The magnetic resonance imaging method as set forth in claim 12, wherein the sub-set is biased toward a 90° angle between readout magnetic field gradient direction and displacement of the feature of interest.

14. The magnetic resonance imaging method as set forth in claim 9, wherein the determining of a displacement of a feature of interest includes one of:

    measuring a physiological parameter correlated with displacement of the feature of interest, the displacement being determined based on the measured physiological parameter,

extracting a position of the feature of interest from acquired magnetic resonance images, the displacement being determined as displacement of the position of the feature of interest from a reference position, and acquiring magnetic resonance echoes interspersed among the imaging echoes to determine the displacement of the feature of interest.

**Patentansprüche**

1. Magnetresonanz-Bildgebungsgerät, das Folgendes umfasst:

   ein Mittel (10, 44, 46, 50, 52) zum Erfassen radialer Auslesezeilen von Magnetresonanz-Bildgebungsdaten;
   ein Mittel (58) zum Rekonstruieren der erfassten Auslesezeilen zu rekonstruierten Bilddaten;
   ein Mittel (120, 122, 124, 126, 130) zum Ermitteln einer Verschiebung eines interessierenden Merkmals (90) eines der Bildgebung unterzogenen Objekts (16); und
   ein Mittel (134, 140) zum Koordinieren der Richtungen der radialen Auslesezeilen mit der Verschiebung des interessierenden Merkmals (90), **dadurch gekennzeichnet, dass** das Koordinierungsmittel (134, 140) vorgesehen ist, um radiale Auslesezeilen so auszuwählen, dass die Richtungen des Auslesemagnetfeldgradienten quer zu der Verschiebung verlaufen.

2. Magnetresonanz-Bildgebungsgerät nach Anspruch 1, wobei das Bestimmungsmittel (120, 122, 124, 126, 130) aus einer Gruppe ausgewählt wird, die aus Folgendem besteht:

   einem Mittel (122, 124, 126) zum Messen eines mit der Verschiebung des interessierenden Merkmals korrelierten physiologischen Parameters, wobei die Verschiebung basierend auf dem gemessenen physiologischen Parameter ermittelt wird,
   einem Mittel (130) zum Extrahieren einer Position des interessierenden Merkmals aus Magnetresonanz-Bildgebungsdaten, die durch das Erfassungsmittel (10, 44, 46, 50, 52) erfasst wurden, wobei die Verschiebung ermittelt wird als Verschiebung der Position des interessierenden Merkmals aus einer Referenzposition heraus, und
   einem Magnetresonanz-Navigator (130), der mit dem Erfassungsmittel (10, 44, 46, 50, 52) kooperiert.

3. Magnetresonanz-Bildgebungsgerät nach Anspruch 1, wobei das Koordinierungsmittel (134, 140) vorgesehen ist, um eine Erfassungsreihenfolge (136) der radialen Auslesezeilen zu berechnen, wobei sich die Erfassungsreihenfolge (136) darauf konzentriert, die Richtung des Auslesemagnetfeldgradienten quer zu der Verschiebung auszurichten, wobei das Erfassungsmittel (10, 44, 46, 50, 52) die Auslesezeilen von Magnetresonanz-Bildgebungsdaten in der Erfassungsreihenfolge (136) erfasst.

4. Magnetresonanz-Bildgebungsgerät nach Anspruch 1, wobei das Koordinierungsmittel (134) im Wesentlichen gleichzeitig mit dem Erfassungsmittel (10, 44, 46, 50, 52) arbeitet, wobei das Koordinierungsmittel (134) eine Richtung des Auslesemagnetfeldgradienten (136) einer nächsten Auslesezeilenerfassung basierend auf einer vorliegenden Verschiebung des interessierenden Merkmals auswählt.

5. Magnetresonanz-Bildgebungsgerät nach Anspruch 1, wobei das Koordinierungsmittel (134, 140) dafür vorgesehen ist, einen Datensatz von erfassten Auslesezeilen auszuwählen, der eine Untergruppe der erfassten Auslesezeilen ist, wobei sich das Auswählen darauf konzentriert (140), Auslesezeilen auszuwählen, für die die Richtung des Auslesemagnetfeldgradienten quer zu der Verschiebung verläuft, wobei das Rekonstruktionsmittel (58) den Datensatz von erfassten Auslesezeilen zu rekonstruierten Bilddaten rekonstruiert.

6. Magnetresonanz-Bildgebungsgerät nach Anspruch 1, wobei das Koordinierungsmittel (134, 140) weiterhin dafür vorgesehen ist,
   das Erfassungsmittel so zu steuern, dass Auslesezeilen von Magnetresonanz-Bildgebungsdaten mit einer ausgewählten Reihenfolge erfasst werden, und/oder
   einen Datensatz von erfassten Auslesezeilen auszuwählen, der eine Untergruppe der erfassten Auslesezeilen ist, wobei der Datensatz die gewählte Reihenfolge hat, wobei das Rekonstruktionsmittel (58) den Datensatz von erfassten Auslesezeilen zu rekonstruierten Bilddaten rekonstruiert.

7. Magnetresonanz-Bildgebungsgerät nach Anspruch 1, wobei das Koordinierungsmittel (134, 140) dafür vorgesehen ist, eine optimierte Reihenfolge (136) eines Satzes von Auslesezeilen basierend auf einer zyklischen Verschiebungstrajektorie zu ermitteln, wobei das Erfassungsmittel (10, 44, 46, 50, 52) die radialen Auslesezeilen von Magnetresonanz-Bildgebungsdaten mit Hilfe der optimierten Reihenfolge (136) erfasst.

8. Magnetresonanz-Bildgebungsgerät nach Anspruch 7, wobei das Koordinierungsmittel (134) dafür vorgesehen ist, die Reihenfolge des Satzes von Auslesezeilen zu optimieren, um einen Gütefaktor zu minimieren, der das gewählte Verhältnis zwischen der Richtung des Auslesemagnetfeldgradienten und der ermittelten Verschiebung des interessierenden Merkmals angibt.

9. Magnetresonanz-Bildgebungsverfahren, das Folgendes umfasst:

Ermitteln einer Verschiebung eines interessierenden Merkmals eines der Bildgebung unterzogenen Objekts;
Auswählen einer Richtung einer radialen Auslesezeile basierend auf der ermittelten Verschiebung,
Erfassen einer radialen Auslesezeile von Magnetresonanz-Bildgebungsdaten mit Hilfe eines Auslesemagnetfeldgradienten mit der ausgewählten Richtung;
Wiederholen des Ermittelns, Auswählens und Erfassens, um einen Datensatz von radialen Auslesezeilen zu sammeln; und
Rekonstruieren des Datensatzes von radialen Auslesezeilen zu rekonstruierten Bilddaten;

**dadurch gekennzeichnet, dass** das Auswählen einer Richtung das Ausrichten der radialen Auslesezeilenrichtung quer zu der Verschiebung umfasst.

10. Magnetresonanz-Bildgebungsverfahren nach Anspruch 9, wobei das Ermitteln einer Verschiebung eines interessierenden Merkmals wiederholt wird, um eine zyklische Verschiebung des interessierenden Merkmals zu ermitteln, und wobei das Auswählen einer Richtung einer radialen Auslesezeile basierend auf der ermittelten Verschiebung Folgendes umfasst:

Optimieren einer Reihenfolge eines Satzes von Auslesezeilen in Bezug auf die zyklische Verschiebung des interessierenden Merkmals, wobei das Erfassen einer radialen Auslesezeile von Magnetresonanz-Bildgebungsdaten das Erfassen einer Vielzahl von Auslesezeilen in der gewählten Reihenfolge umfasst.

11. Magnetresonanz-Bildgebungsverfahren nach Anspruch 10, wobei das Optimieren der Reihenfolge derart erfolgt, dass bei einer großen Verschiebung des interessierenden Merkmals die erfasste radiale Auslesezeile eine Richtung hat, die im Wesentlichen orthogonal zu der großen Verschiebung gewählt wird.

12. Magnetresonanz-Bildgebungsverfahren nach Anspruch 9, wobei das Ermitteln einer Verschiebung eines interessierenden Merkmals wiederholt wird, um eine zyklische Verschiebung des interessierenden Merkmals zu ermitteln, und wobei das Auswählen einer Richtung einer radialen Auslesezeile basierend auf der ermittelten Verschiebung Folgendes umfasst:

Auswählen einer Untergruppe der erfassten radialen Auslesezeilen basierend auf einem Winkel zwischen der Auslesezeile und der Verschiebung des interessierenden Merkmals zum Zeitpunkt der Erfassung der Auslesezeile, wobei das Rekonstruieren für die gewählte Untergruppe erfolgt.

13. Magnetresonanz-Bildgebungsverfahren nach Anspruch 12, wobei sich die Untergruppe auf einen 90-Grad-Winkel zwischen der Richtung des Auslesemagnetfeldgradienten und der Verschiebung des interessierenden Merkmals konzentriert.

14. Magnetresonanz-Bildgebungsverfahren nach Anspruch 9, wobei das Ermitteln einer Verschiebung eines interessierenden Merkmals einen der folgenden Schritte umfasst:

Messen eines physiologischen Parameters, der mit der Verschiebung des interessierenden Merkmals korreliert, wobei die Verschiebung basierend auf dem gemessenen physiologischen Parameter ermittelt wird,
Extrahieren einer Position des interessierenden Merkmals aus erfassten Magnetresonanzbildern, wobei die Verschiebung als Verschiebung der Position des interessierenden Merkmals aus einer Referenzposition heraus ermittelt wird, und
Erfassen von unter die Bildgebungsechos eingestreuten Magnetresonanzechos , um die Verschiebung des interessierenden Merkmals zu ermitteln.

**Revendications**

1. Appareil d'imagerie par résonance magnétique comprenant:

des moyens (10, 44, 46, 50, 52) pour acquérir des lignes radiales de lecture des données d'imagerie par résonance magnétique;
des moyens (58) pour reconstruire les lignes de lecture acquises en des données d'image reconstruites;
des moyens (120, 122, 124, 126, 130) pour déterminer un déplacement d'un dispositif d'intérêt (90) d'un objet (16) subissant une imagerie; et
des moyens (134, 140) pour coordonner les directions des lignes radiales de lecture avec le déplacement du dispositif d'intérêt (90), **caractérisé en ce que** les moyens de coordination (134, 140) sont agencés de manière à sélectionner des lignes radiales de lecture pour acquérir des directions de gradient de champ magnétique de lecture qui sont transversales au déplacement.

2. Appareil d'imagerie par résonance magnétique, tel que défini dans la revendication 1, dans lequel les moyens de détermination (120, 122, 124, 126, 130) sont sélectionnés parmi un groupe constitué de:

moyens (122, 124, 126) pour mesurer un paramètre physiologique qui est corrélé avec le déplacement du dispositif d'intérêt, le déplacement étant déterminé sur la base du paramètre physiologique mesuré,
moyens (130) pour extraire une position du dispositif d'intérêt à partir des données d'imagerie par résonance magnétique qui son acquises par des moyens d'acquisition (10, 44, 46, 50, 52), le déplacement étant déterminé en tant que déplacement de la position du dispositif d'intérêt à partir d'une position de référence, et
un navigateur à résonance magnétique (130) coopérant avec les moyens d'acquisition (10, 44, 46, 50, 52).

3. Appareil d'imagerie par résonance magnétique, tel que défini dans la revendication 1, dans lequel les moyens de coordination (134, 140) sont agencés de manière à calculer un ordre d'acquisition (136) des lignes radiales de lecture, l'ordre d'acquisition (136) étant polarisé vers l'orientation de la direction de gradient de champ magnétique de lecture qui est transversale au déplacement, les moyens d'acquisition (10, 44, 46, 50, 52) acquérant les lignes de lecture des données d'imagerie par résonance magnétique dans l'ordre d'acquisition (136).

4. Appareil d'imagerie par résonance magnétique, tel que défini dans la revendication 1, dans lequel les moyens de coordination (134) fonctionnent sensiblement d'une manière simultanée avec les moyens d'acquisition (10, 44, 46, 50, 52), les moyens de coordination (134) sélectionnant une direction de gradient de champ magnétique de lecture (136) d'une prochaine acquisition de lignes de lecture qui est basée sur un présent déplacement du dispositif d'intérêt.

5. Appareil d'imagerie par résonance magnétique, tel que défini dans la revendication 1, dans lequel les moyens de coordination (134, 140) sont agencés de manière à sélectionner un ensemble de données des lignes de lecture acquises qui constitue un sous-ensemble de lignes de lecture acquises, la sélection étant polarisée (140) vers la sélection des lignes de lecture pour lesquelles la direction de gradient de champ magnétique de lecture est transversale au déplacement, les moyens de reconstruction (58) reconstruisant l'ensemble de données des lignes de lecture acquises en des données d'image reconstruites.

6. Appareil d'imagerie par résonance magnétique, tel que défini dans la revendication 1, dans lequel les moyens de coordination (134, 140) sont encore agencés de manière à:

commander les moyens d'acquisition pour acquérir les lignes de lecture des données d'imagerie par résonance magnétique ayant un ordre sélectionné, et/ou
sélectionner un ensemble de données des lignes de lecture acquises qui constitue un sous-ensemble de lignes de lecture acquises, l'ensemble de données ayant l'ordre sélectionné, les moyens de reconstruction (58) reconstruisant l'ensemble de données des lignes de lecture acquises en des données d'image reconstruites.

7. Appareil d'imagerie par résonance magnétique, tel que défini dans la revendication 1, dans lequel les moyens de coordination (134, 140) sont agencés de manière à déterminer un ordre optimisé (136) d'un ensemble de lignes de lecture sur la base d'une trajectoire de déplacement cyclique, les moyens d'acquisition (10, 44, 46, 50, 52) acquérant les lignes radiales de lecture des données d'imagerie par résonance magnétique en utilisant l'ordre optimisé (136).

8. Appareil d'imagerie par résonance magnétique, tel que défini dans la revendication 1, dans lequel les moyens de coordination (134) sont agencés de manière à optimiser l'ordre de l'ensemble de lignes de lecture pour minimiser un facteur de mérite qui est indicatif de la relation sélectionnée entre la direction de gradient de champ magnétique de lecture et le déplacement déterminé du dispositif d'intérêt.

9. Procédé d'imagerie par résonance magnétique comprenant:

la détermination d'un déplacement d'un dispositif d'intérêt d'un objet subissant une imagerie;
la sélection d'une direction d'une ligne radiale de lecture qui est basée sur le déplacement déterminé,
l'acquisition d'une ligne radiale de lecture des données d'imagerie par résonance magnétique à l'aide d'un gradient de champ magnétique de lecture ayant la direction sélectionnée;
la répétition de la détermination, de la sélection et de l'acquisition pour recueillir un ensemble de données des lignes radiales de lecture; et
la reconstruction de l'ensemble de données des lignes radiales de lecture en des données d'image reconstruites;

**caractérisé en ce que** la sélection d'une direction inclut l'orientation de la direction des lignes radiales de lecture qui est transversale au déplacement.

10. Procédé d'imagerie par résonance magnétique, tel que défini dans la revendication 9, dans lequel la détermination d'un déplacement d'un dispositif d'intérêt est répétée pour déterminer un déplacement cyclique du dispositif d'intérêt et dans lequel la sélection d'une direction d'une ligne radiale de lecture qui est basée sur le déplacement déterminé inclut:

l'optimisation d'un ordre d'un ensemble de lignes de lecture par rapport au déplacement cyclique du dispositif d'intérêt, l'acquisition d'une ligne radiale de lecture des données d'imagerie par résonance magnétique incluant l'acquisition d'une pluralité de lignes de lecture dans l'ordre sélectionné.

11. Procédé d'imagerie par résonance magnétique, tel que défini dans la revendication 10, dans lequel l'optimisation de l'ordre est telle que, lorsque le déplacement du dispositif d'intérêt est grand, la ligne radiale de lecture acquise présente une direction qui est sélectionnée d'une manière sensiblement orthogonale par rapport au grand déplacement.

12. Procédé d'imagerie par résonance magnétique, tel que défini dans la revendication 9, dans lequel la détermination d'un déplacement d'un dispositif d'intérêt est répétée pour déterminer un déplacement cyclique du dispositif d'intérêt et dans lequel la sélection d'une direction d'une ligne radiale de lecture qui est basée sur le déplacement déterminé inclut:

la sélection d'un sous-ensemble de lignes radiales de lecture acquises sur la base d'un angle entre la ligne de lecture et le déplacement du dispositif d'intérêt à l'époque où la ligne de lecture a été acquise, la reconstruction étant exécutée sur le sous-ensemble sélectionné.

13. Procédé d'imagerie par résonance magnétique, tel que défini dans la revendication 12, dans lequel le sous-ensemble est polarisé vers un angle de 90° entre la direction de gradient de champ magnétique de lecture et le déplacement du dispositif d'intérêt.

14. Procédé d'imagerie par résonance magnétique, tel que défini dans la revendication 9, dans lequel la détermination d'un déplacement d'un dispositif d'intérêt inclut une des étapes suivantes consistant à:

mesurer un paramètre physiologique qui est corrélé avec le déplacement du dispositif d'intérêt, le déplacement étant déterminé sur la base du paramètre physiologique mesuré,
extraire une position du dispositif d'intérêt à partir des images de résonance magnétique acquises, le déplacement étant déterminé en tant que déplacement de la position du dispositif d'intérêt à partir d'une position de référence, et
l'acquisition des échos de résonance magnétique qui sont entremêlés parmi les échos d'imagerie pour déterminer le déplacement du dispositif d'intérêt.

FIG 1

FIG 2

EP 1 685 421 B1

FIG 3

**EP 1 685 421 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0218838 A2